# EUROPEAN PATENT APPLICATION

(11) **EP 3 159 981 A1**
(43) Date of publication of application: **26.04.2017**
(21) Application number: 16193919.4
(22) Date of filing: 14.10.2016
(51) Int. Cl.: H01S 5/024, H01S 5/40

(54) **THERMALLY CONDUCTIVE, CURRENT CARRYING, ELECTRICALLY ISOLATED SUBMOUNT FOR LASER DIODE ARRAYS**

(30) Priority: 22.10.2015 US 201514920574
(71) Applicant: Northrop Grumman Space & Mission Systems Corporation, Los Angeles 90067 (US)
(72) Inventor: JUNGHANS, Jeremy Scott, Saint Charles, MO Missouri 63304 (US); FEELER, Courtney Ryan, Rolla, MO Missouri 65401 (US); STEPHENS, Edward F., Golden Eagle, IL Illinois 62036 (US)
(74) Representative: Guardian IP Consulting I/S

(57) **Abstract**

A laser diode array having submounts allowing thermal transmission from laser diode bars to a heat exchanger while electrically isolating the laser diode bars from the heat exchanger. The laser diode array has a plurality of laser diode bars supported by a corresponding plurality of submounts. Each of the submounts has a submount core having a top surface, an opposite bottom surface and side surfaces. An electrically conductive layer covers part of one side surface. The conductive layer is in electrical contact with one of the laser diode bars. Another electrically conductive layer covers part of a second side surface. An electrical connector connects the electrically conductive layers on the side surfaces. The electrically conductive layers leave an exposed area of the side surfaces adjacent to the bottom surface. The heat exchanger is in thermal contact with the bottom surface of each of the submount cores.

## Description

### TECHNICAL FIELD

The present invention relates generally to laser diode systems and, in particular, to an electrically isolated submount for a laser diode bar that provides sufficient electrical connection to the laser diode bar and thermal connection to a heat exchanger while electrically isolating the heat exchanger.

### BACKGROUND

Semiconductor laser diodes have numerous advantages. They are small in that the widths of their active regions are typically submicron to a few microns and their heights are usually no more than a fraction of a millimeter. The length of their active regions is typically less than about a millimeter. The internal reflective surfaces, which produce emission in one direction, are formed by cleaving the substrate from which the laser diodes are produced and, thus, have high mechanical stability.

High efficiencies are possible with semiconductor laser diodes with some pulsed junction laser diodes having external quantum efficiencies near 50%. Semiconductor lasers produce radiation at wavelengths from about 0.6 to about 3.0 microns depending on the semiconductor alloy that is used. For example, laser diodes made of gallium arsenide with aluminum doping (AlGaAs) emit radiation at approximately 0.8 microns (~ 800 nm) which is near the absorption spectrum of common solid state laser rods and slabs made from Neodymium doped, Yttrium-Aluminum Garnet (Nd:YAG), and other crystals and glasses. Thus, semiconductor laser diodes can be used as the optical pumping source for larger, solid state laser systems.

Utilization of semiconductor laser diodes has been restricted by thermally related problems. These problems are associated with the large heat dissipation per unit area of the laser diodes which results in elevated junction temperatures and stresses induced by thermal cycling. Laser diode efficiency and the service life are decreased as the operating temperature in the junction increases.

Furthermore, the emitted wavelength of a laser diode is a function of its junction temperature. Thus, when a specific output wavelength is desired, maintaining a constant junction temperature is essential. For example, AlGaAs laser diodes that are used to pump a Nd:YAG rod or slab should emit radiation at about 808 nm since this is the wavelength at which optimum energy absorption exists in the Nd:YAG. But, for every 3.5 °C to 4.0 °C deviation in the junction temperature of the AlGaAs laser diode, the wavelength shifts 1 nm. Accordingly, controlling the junction temperature and, thus, properly dissipating the heat is critical.

When solid state laser rods or slabs are pumped by laser diodes, dissipation of the heat becomes more problematic since it becomes necessary to densely pack a plurality of individual diodes into arrays which generate the required amounts of input power for the larger, solid state laser rod or slab. However, when the packing density of the individual laser diodes is increased, the space available for extraction of heat from the individual laser diodes decreases. This aggravates the problem of heat extraction from the arrays of individual diodes.

To remove heat from the laser diodes, some laser diode array packages have used beryllium oxide which has a relatively high thermal conductivity while being electrically insulative. One known package which attempts to resolve these thermally-related problems by use of beryllium oxide is shown in U.S. Patent No. 5,040,187. This package generally includes a beryllium oxide structure into which a plurality of grooves are cut, etched or sawed. A metallized layer extends from groove to groove to conduct electricity through the laser diodes that are within the grooves.

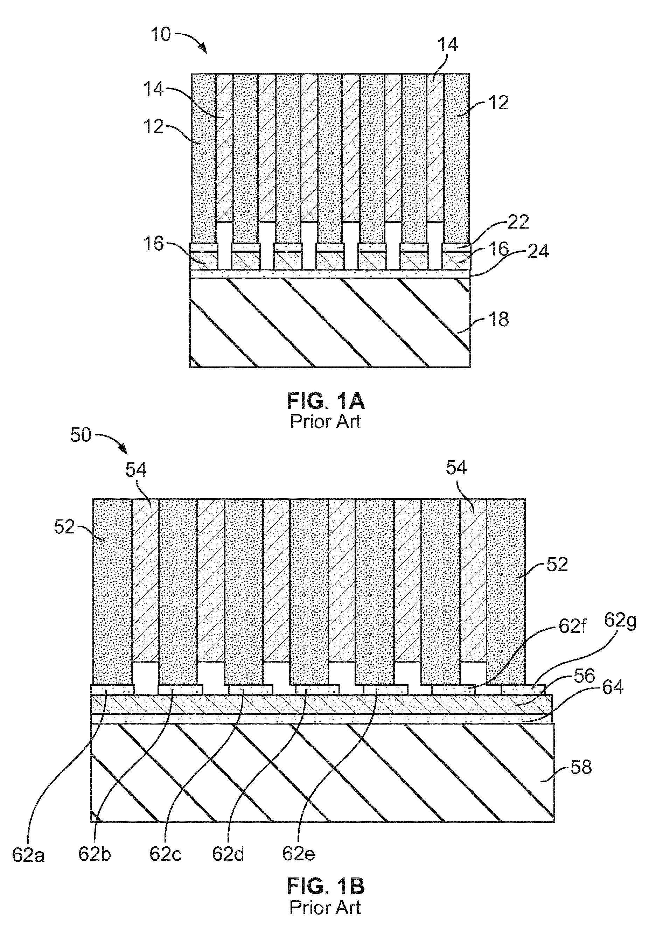

FIG. 1A is a cross-section view of another prior art laser diode array 10 including a series of submounts 12 that provide a base for the laser diodes 14 and remove heat from the laser diodes 14. In this example, the submounts 12 may be entirely composed of a thermally and electrically conductive material or alternately have a conductor layer over a substrate of non-conductive material. The submounts 12 provide electrical contact with the laser diodes 14. Each laser diode 14 is electrically connected in series to the neighboring laser diode 14. The submounts 12 provide current to the junction of the laser diode 14 via the conductive layers.

Each submount 12 is thermally coupled to substrates 16 that are in turn bonded to a metal-based heat exchanger 18. Two separate solder bonds 22 and 24 are required for each diode submount 12, not including the bond between the diode 14 and submount 12, in such a configuration. The first solder bonds 22 bond the submounts 12 to the respective substrates 16 and the second solder bonds 24 join the substrates 16 to the heat exchange mechanism 18. The substrates 16 in such a configuration must therefore be thick enough to ensure that the operating voltage does not exceed the breakdown voltage of the air gap between the solder bonds 22 or an additional insulating (potting) material must be added. This is particularly challenging for large arrays that operate at high voltages. Increasing the thickness of the substrates 16 to provide the adequate insulation for the submounts 12 also results in an increased distance between the heat source in the form of the laser diodes 14 and the heat exchanger 18, which is thermally undesirable.

An alternative is the use of a single insulating substrate as shown in another prior art laser diode system 50 in FIG. 1B. The laser diode system 50 has a series of submounts 52 that provide a base for the laser diodes 54. The submounts 52 have conductive layers over an electrically non-conductive core to provide electrical contact with the laser diodes 54.

A substrate 56 is attached to the plurality of submounts 52 via isolated solder pads 62a-62g. The electrically non-conductive substrate 56 allows the laser diode bars 54 and submounts 52 to be electrically isolated from a metal heat exchanger 58. This prevents electrical shorting of the submounts 52 and maintains a series connection of the laser diodes 54 as current must pass through the diodes 54 and also maintains electrical isolation of the heat exchanger 58.

The bottom surface of the substrate 56 is in turn soldered via a solder layer 64 to the heat exchanger 58.

The use of the single substrate 56 in the system 50 has the potential for misalignment of the solder pads 62a-62g connecting the submounts 52 to the substrate 56 due to tolerance stacking. The single substrate 56 for a large array requires that precise diode pitch be maintained across the entire array. The smaller the diode pitch, the more problematic this becomes. Thin submounts must be used to achieve a tight diode-to-diode pitch (e.g., 250 micron thick submounts commonly used to achieve 400 micron diode pitch). As a result, the contact area between the submounts 52 and the substrate 56 is relatively small. While small variations in the thicknesses of the material (e.g., diode, submount or solder) will have minimal effect on the diode pitch, the tolerance stack up may result in considerable misalignment of the submounts 52 to the solder pads 62a-62g on the substrate. For instance, a 2.5% variation in material thickness on a 400 micron pitch array results in up to a 22% reduction in total bonding area for a 10-bar array, a 32% reduction for a 15-bar array and a 36% reduction in total bonding area for a 20-bar array. Moreover, a single submount could be misaligned by as much as 40%, 60% or 80% respectively for a 10-, 15-, or 20-bar array even though the pitch is only off by 2.5%. This may have a significant effect on the performance and reliability of the array since the direct thermal path from the diodes 54 is through the bond. As shown in FIG. 1B, the solder bonds 62c-62g become increasing misaligned with the corresponding submounts 52 and therefore the area of thermal conductivity between the submounts 52 and the substrate 56 is reduced, thereby compromising the heat removal from the diodes 54.

Thus, there is a need for a laser diode array without an electrically isolating substrate that maintains electrical isolation between the submounts and the underlying heat exchanger. There is also a need for a laser diode array that insures the necessary solder bonds between the submounts and the heat exchanger. There is also a need for a laser diode array having solder bonds between submounts and the heat exchanger that provide maximum surface contact for thermal transmission.

### SUMMARY

According to one example, a laser diode array includes a plurality of laser diode bars and a plurality of submounts supporting one of the laser diode bars. Each of the plurality of laser diode bars includes a first contact surface and an opposite second contact surface. Each of the plurality of submounts includes an electrically insulative submount core having a top surface, an opposite bottom surface, and first and second side surfaces. A first electrically conductive layer covers only a part of a first side surface thereby leaving an exposed area of the first side surface adjacent to the bottom surface. A second electrically conductive layer covers only a part of a second side surface thereby leaving an exposed area of the second side surface adjacent to the bottom surface. An electrical connector is located between the first and second electrically conductive layers. A metallic heat exchanger is in thermal contact with the bottom surface. The first contact surface of each of the diode bars is directly adjacent to and in electrical contact with the first conductive layer of one of the plurality of submounts and the second contact surface of each of the diode bars is directly adjacent to and in electrical conduct with the second conductive layer of another one of the plurality of submounts such that only a single laser diode bar separates the one of the submounts from the another one of the submounts.

Another example is a laser diode package in an assembly to be used in a laser diode array having a plurality of laser diode packages. The laser diode package has a first submount having an electrically insulative core with a top surface, a bottom surface, and first and second side surfaces located between the top and bottom surfaces. The first submount has a continuous electrically conductive layer positioned on the top surface and on portions of the first and second side surfaces adjacent to the top surface. A lowermost end of the continuous electrically conductive layer on each of the first and second side surfaces is spaced away from the bottom surface of the electrically insulative core. A laser diode bar includes a first contact and a second contact opposite the first contact. The first contact is attached via a solder bond to the first side surface such that the laser diode emits energy from a region adjacent to the top surface. A second submount has an electrically insulative core with a top surface, a bottom surface, and first and second side surfaces located between the top and bottom surfaces. The first submount has a continuous electrically conductive layer positioned on the top surface and on portions of the first and second side surfaces adjacent to the top surface, a lowermost end of the continuous electrically conductive layer on each of the first and second side surfaces being spaced away from the bottom surface of the electrically insulative core. The second submount is attached to the second contact of the laser diode bar via a solder bond to second side surface, such that only the laser diode bar separates the first and second submounts.

Another example is a laser diode array including a plurality of laser diode packages. Each of the packages include a submount having an electrically insulative core with a top surface, a bottom surface, and first and second side surfaces located between the top and bottom surfaces. The submount has a continuous electrically conductive layer positioned on the top surface and on portions of the first and second side surfaces adjacent to the top surface. A lowermost end of the continuous electrically conductive layer on each of the first and second side surfaces is spaced away from the bottom surface of the electrically insulative core. A laser diode bar is attached via a solder foil layer to the first side surface such that the laser diode emits energy from a region adjacent to the top surface. A thermal reservoir is thermally coupled to the bottom surfaces of each submount via a lower temperature solder than the solder foil layer. The laser diode bar is attached via another solder foil layer to a second side surface of another submount of another laser diode package of the plurality of the laser diode packages such that only the laser diode bar separates the submount from the another submount.

In the above example, the distance from the lowermost end of the continuous electrically conductive layer to the bottom layer may be between about 20% to 40% of the distance between the top and bottom surface. The electrically insulative core may be composed of one of the group of Aluminum Nitride (AlN), Beryllium Oxide (BeO) or CVD Diamond. The solder bonds may be a gold-tin solder. The conductive layer may be one of a group of copper, gold, nickel, titanium and platinum.

The above summary of the present invention is not intended to represent each embodiment or every aspect of the present invention. The detailed description and Figures will describe many of the embodiments and aspects of the present invention.

### BRIEF DESCRIPTION OF THE DRAWINGS

The foregoing and other advantages of the invention will become apparent upon reading the following detailed description and upon reference to the drawings.
FIG. 1A is a cross-section view of a prior art laser diode mounting system having multiple substrates;
FIG. 1B is a cross-section view of a prior art laser diode mounting system with a single substrate showing the potential for misalignment due to tolerance stacking;
FIG. 2 is view of a laser diode array assembly using isolated submounts without a substrate layer;
FIG. 3A is a side view of the isolated submounts and laser diode bars in the system in FIG. 2;
FIG. 3B is an exploded view of the components of an isolated submount and laser diode bar in FIG. 3A;
FIG. 4 is a side view of an alternate isolated submount and laser diode bar suitable for use in the system in FIG. 2; and
FIG. 5 is a cross-section view of another alternate isolated submount suitable for use in the system in FIG. 2.

While the invention is susceptible to various modifications and alternative forms, specific embodiments have been shown by way of example in the drawings and will be described in detail herein. It should be understood, however, that the invention is not intended to be limited to the particular forms disclosed. Rather, the invention is to cover all modifications, equivalents, and alternatives falling within the spirit and scope of the invention as defined by the appended claims.

### DESCRIPTION OF ILLUSTRATIVE EMBODIMENTS

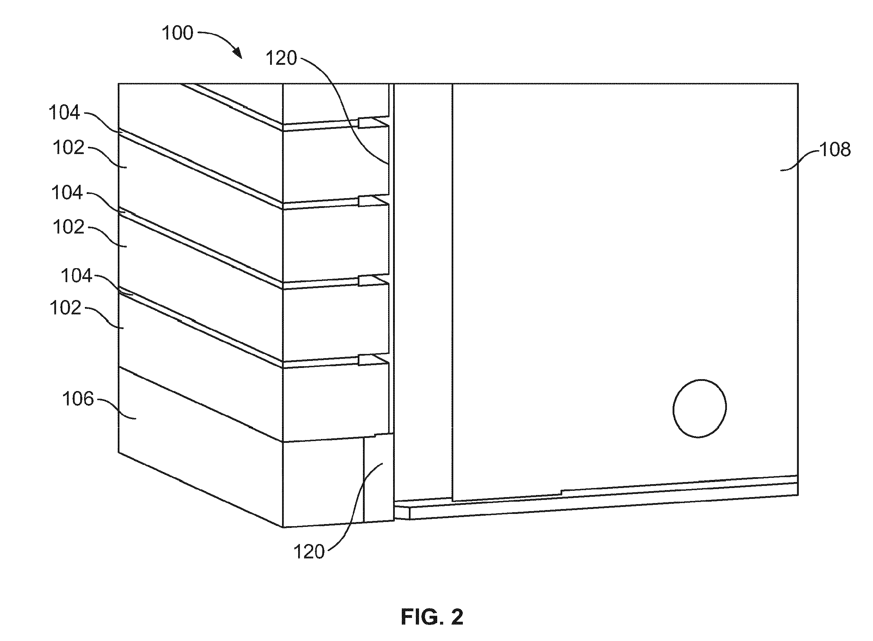

FIG. 2 is a perspective view of a laser diode array system 100 allowing transverse emission of light from laser diode bars 104 supported by submounts 102. The laser diode bars 104 and submounts 102 are arranged in alternating order so the laser diode bars 104 are electrically connected in series. An end block 106 supports the submounts 102 and provides electrical power to the first submount 102. The submounts 102 are thermally coupled to a heat exchanger 108 to allow thermal transmission of heat generated by the laser diode bars 104 to the heat exchanger 108. An internal network of conduits in the heat exchanger 108 allows circulation of coolant to assist in dissipation of heat. The heat exchanger 108 in this example is a thermally conductive material such as copper for maximum thermal conduction.

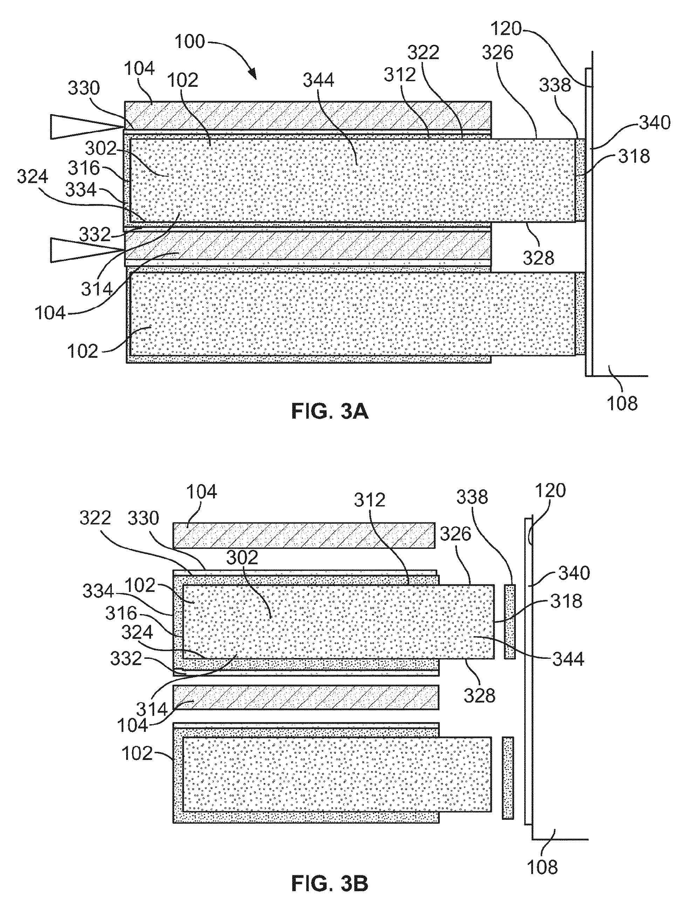

FIG. 3A shows a close up side view of two sets of the submounts 102 and laser diode bars 104 in FIG. 2. FIG. 3B shows an exploded view of the components of the submounts 102 and the laser diode bars 104 in FIG. 3A. The laser diode bars 104 each have a p-side contact and an opposite n-side contact and emit laser light when electrical current is applied between the p-side contact and the n-side contact. It is to be understood that the submounts 102 are similar and the below description relating to the top submount 102 in FIG. 3A applies to the other submounts 102 in FIG. 2.

A core 302 of the submount 102 is fabricated from a dielectric material that also possesses a high thermal conductivity such as Aluminum Nitride (AlN), Beryllium Oxide (BeO) or CVD Diamond. In this example, the core 302 is fabricated from BeO. The submount core 302 has a roughly rectangular slab-like shape with a first side surface 312 and an opposite side surface 314. A top surface 316 is opposite to a bottom surface 318 that is coupled to the top surface 120 of the heat exchanger 108 in FIG. 2.

The side surface 312 includes an electrically conductive pad or layer such as a metal layer 322 that extends over part of the side surface 312. Similarly, the side surface 314 includes an electrically conductive pad or layer 324 that extends over part of the side surface 314. Thus, the side surface 312 includes an exposed area 326 adjacent to the bottom surface 318 and the opposite side surface 314 includes an exposed area 328 adjacent to the bottom surface 318 to provide electrical isolation between the metal layers 322 and 324 and the heat exchanger 108. The metal layers 322 and 324 may be applied by plating, sputtering or metal evaporation. In this example, the metal layers 322 and 324 are predominantly copper but other electrically conductive elements and/or their respective alloys, including gold, nickel, titanium, platinum, etc. may be used. In this example, the distance between the side surfaces 312 and 314 may range between 0.4 and 2.00 mm with the distance in FIG. 3A being 1.5 mm and 2.4 mm between the top surface 316 and the bottom surface 318. The side surfaces 312 and 314 are approximately 10mm wide. The metal layers 332 and 334 are approximately 0.015mm thick.

The metal layer 322 serves as the mounting surface and electrical contact for one side of the diode bar 104 and the layer 324 interfaces the side of the adjacent diode bar 104 on the next submount 102 as shown in FIG. 3A. A layer of pre-deposited solder 330 is applied to join the metal layer 322 to either the n-side contact or the p-side contact of the laser diode bar 104. In this example, the pre-deposited solder 330 and therefore the metal layer 322 is electrically in contact with p-side contact of the laser diode bar 104. Each metal layer 322 and 324 extends from one side (emitting facet) of the laser diode bar 104 to approximately the opposite side (HR facet) of the laser diode bar 104. A solder foil 332 is applied to join the metal layer 324 to either the n-side contact or the p-side contact of the next laser diode bar 104. The n-side contact or the p-side contact of the next laser diode bar 104 joined to the metal layer 324 will be the opposite of the p-side contact or the n-side contact of the laser diode bar 104 joined to the metal layer 322. In this example, the n-side contact of the next laser diode bar 104 is joined to the metal layer 324 via the solder foil 332.

The two metal layers 322 and 324 are electrically connected to each other to provide a series connection between the diode bars 104 on the top and the bottom of the submounts 102. In this example, the top surface 316 includes a metal layer 334 that is joined to the layers 322 and 324 to allow electrical conduction between the layers 322 and 324. The metal layers 322, 324 and 334 may be a single sheet that is wrapped around the core 302 on the respective side surfaces 312 and 314 and the top surface 316. As shown in FIG. 3A, a lateral side surface 344 between the top and bottom surfaces 312 and 314 of the submount core 302 is exposed without a covering metal layer. The lateral side surface (not shown) opposite the pictured lateral side surface 344 is also exposed. A metal layer 338 is applied to the bottom surface 318 of the submount core 302 to allow it to be soldered to the heat exchanger 108 via a solder layer 340. The metal layer 338 is electrically isolated from the top and bottom layers 322 and 324 by the exposed areas 326 and 328 of the core 302. In this example, the distance from the lowermost end of the continuous electrically conductive metal layers 322 and 324 to the bottom metal layer 338 is between about 20% to 40% of the distance between the top surface 316 and the bottom surface 318. In this example, the solder layers 330 and 332 may be 75/25 Au-Sn pre-deposited solder or solder foil on the metal layers 322 and 324. The 75/25 Au-Sn solder changes to an 80/20 mix by diffusing gold from the laser diode 104 during the heating process in assembling the diode array. The solder may also be an 80/20 Au-Sn pre-deposited solder or preform solder. The solder in the solder layer 340 is a lower temperature solder such as indium.

Each bar 104 and its submount 102 in FIG. 1 may be considered a laser diode package. The laser diode array 100 is therefore assembled from multiple packages. Each laser diode package may then be inspected before assembling the overall array. Adjacent laser packages are soldered via a gold/tin foil piece placed between the submount 102 on one laser diode package and the laser diode 104 of the adjacent package.

As shown in detail in FIG. 3A, the laser diode bars 104 are electrically isolated from a top surface 120 of the heat exchanger 108 in FIG. 2. Each of the submounts 102 includes a core dielectric material and electrically conductive pads or layers partially covering surfaces of the core that serve as the mounting surfaces and electrical contact of the side of the laser diode bars 104. The conductive pad or layer on one side of the core is connected to another conductive pad or layer on the other side of the core that partially covers the opposite surface of the submount 102 and serves as an electrical contact for the side of the next laser diode bar 104 in sequence. Since the conductive pads only cover part of the surface of the submount 102, the laser diode bars 104 are electrically insulated from the heat exchanger 108 as shown in FIG. 3A. In this manner, the submounts 102 are thermally conductive to the heat exchanger 108 and carry current from the outer conductive pads. However, the submounts 102 are electrically isolated from the heat exchanger 108 because the conductors only partially cover the side surfaces of the core. The electrical isolation is necessary as short circuits between the laser diode bars 104 via the conductive nature of the metal heat exchanger 108 must be avoided for proper operation of the array system 100.

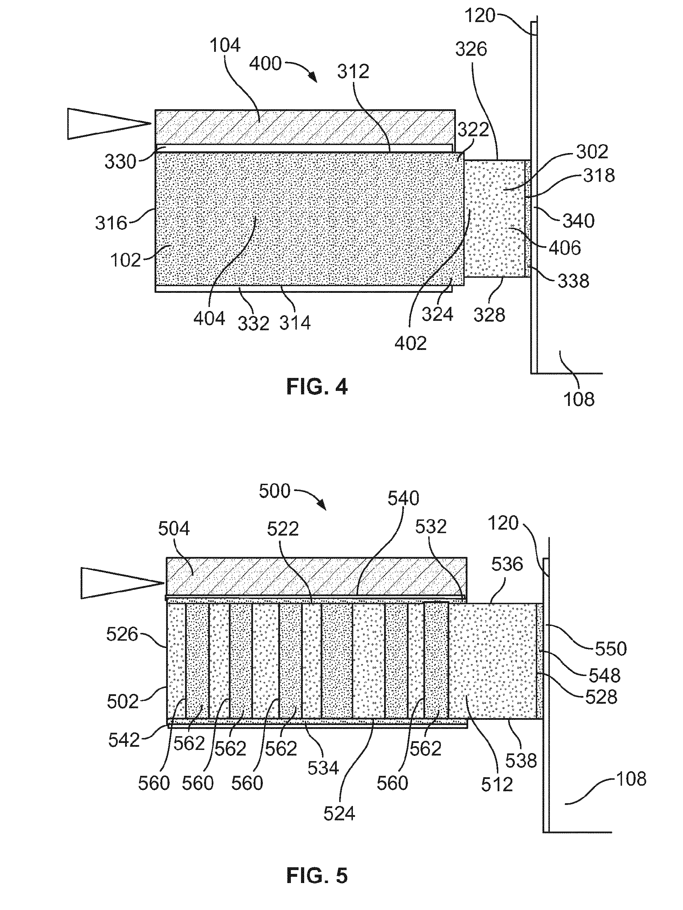

FIG. 4 shows a cross-section view of an alternative electrically isolated submount assembly 400 that may be used for one of the sets of submounts 102 and laser diode bars 104 in FIG. 2. The electrically isolated submount assembly 400 is similar to the submount assembly shown in FIG. 3 and thus like elements are designated by elements in FIG. 4. The only difference is that the submount core 312 has a lateral side surface 402 that includes a metal side layer 404 that is joined to the two metal layers 322 and 324 to allow electrical conduction between the two metal layers 322 and 324. The metal layer 404 only partially extends over the lateral side surface 402 leaving an exposed area 406 to provide electrical isolation from the heat exchanger 108. Another side layer may be applied to the opposite lateral side surface of the submount core 312 to further connect the two metal layers 322 and 332.

The example submount 104 in FIG. 3A does not require additional metal layers on the lateral side surfaces 344 in contrast to the side metal layers of the submount assembly 400 in FIG. 4. This assists in simpler fabrication and assembly of the submount 102 in FIG. 3A.

FIG. 5 shows an alternate electrically isolated laser diode package 500 that may be used for one or more of the sets of submounts 102 and laser diode bars 104 in FIG. 1. The electrically isolated laser diode package 500 includes a submount 502 and a laser diode bar 504. The laser diode bar 504 emits laser light when electrical current is applied. In this example, a submount core 512 is fabricated from Beryllium Oxide (BeO), but other thermally conductive materials may be used as explained above. The submount core 512 has a roughly rectangular slab-like shape with a side surface 522 and an opposite side surface 524. A top surface 526 is opposite to a bottom surface 528 that is thermally coupled to the top surface 120 of the heat exchanger 108 in FIG. 2.

The side surface 522 includes a metal layer 532 that extends over part of the side surface 522. Similarly, the side surface 524 includes a metal layer 534 that extends over part of the side surface 524. Thus, the side surface 522 includes an exposed area 536 adjacent to the bottom surface 528 and the side surface 524 includes an exposed area 538 adjacent to the bottom surface 528 to provide electrical isolation between the metal layers 532 and 534 and the heat exchanger 108.

The metal layer 532 serves as the mounting surface and electrical contact for the side of the laser diode bar 504 and the metal layer 534 interfaces the side of the adjacent diode bar from the next submount. A layer of solder 540 is applied to join the metal layer 532 to the side of the laser diode bar 504. A solder foil 542 is applied to join the metal layer 534 to the side of the next laser diode bar. In this example, the solder 540 and solder foil 542 is a 75/25 Au-Sn solder. Each metal layer 532 and 534 extends from one side (emitting facet) of the laser diode bar 504 to approximately the opposite side (HR facet) of the laser diode bar 504.

A metal layer 548 is applied to the bottom surface 528 of the submount 512 to allow it to be soldered to the heat exchanger 108 via a solder layer 550. The metal layer 548 is electrically isolated from the metal layer 532 and 534 via the exposed areas 536 and 538.

The two metal layers 532 and 534 are electrically connected to each other to provide a series connection between the laser diode bar 504 and the next laser diode bar. In this example, the submount core 512 has a series of lateral vias 560 that extend from the side surface 522 to the side surface 524. The width of the vias 560 may be a ratio of 1 to 1.5 of the core material between the vias 560 in this example, but other ratios may be used for the width of the vias 560 relative to the core material between the vias 560. In this example, the vias 560 are filled with conductive material 562 such as copper that connects the metal layers 532 and 534. Alternatively, the sides of the vias 560 may be coated with the conductive material to allow for thermal expansion during fabrication of the assembly 500. The use of the vias 560 provides more direct electrical connection between the n-side contacts and the p-side contacts of the diode bars than the submount assemblies shown in FIGs. 3 and 4 and avoids the need for additional conductive layers on other sides of the submount.

The electrically isolated submount assemblies shown in FIGs. 3, 4 and 5 allow the previously required insulating substrate in FIGs. 1A and 1B to be eliminated in the laser diode assembly 100 in FIG. 2 and subsequently mitigate the concerns relating to electrical isolation of the diode bars. A single solder material may be used to bond each submount to the heat exchanger. This eliminates the lowest melting point solder from the solder hierarchy and enables increased flexibility in material choices and facilitates operation of the laser diode array at higher temperatures. Furthermore, the submount designs reduce the total number of solder joints within the array improving reliability and simplifying the assembly process. The isolated electrically thermally conductive region of the submounts in FIGs. 3-5 is designed to provide sufficient electrical insulation from the heat exchanger and the other diode bars. The dielectric properties of the core of the submounts allow them to be bonded directly to the heat exchanger. The overall laser diode array system 100 also does not need to be paired with a substrate that has solder pads of the same pitch, and therefore it is not affected by tolerance stack up. The bonding area of like sized arrays will be nearly equivalent regardless of slight variations in pitch. Finally, the elimination of the individual substrates reduces the total number of components required for a laser diode array which simplifies assembly and lowers cost. The assembly of single laser diodes stacked between the submounts allows efficient removal of heat from the laser diode bars via the attached submounts and the laser diode array in Fig. 2 may be operated at high duty cycles up to and including continuously (100% duty cycle).

While the present invention has been described with reference to one or more particular embodiments, those skilled in the art will recognize that many changes may be made thereto without departing from the spirit and scope of the present invention. Each of these embodiments and obvious variations thereof is contemplated as falling within the spirit and scope of the claimed invention, which is set forth in the following claims.

## Claims

1. A laser diode array comprising:
a plurality of laser diode bars;
a plurality of submounts supporting one of the laser diode bars, at least one of the plurality of submounts including:
an electrically insulative submount core having a top surface, an opposite bottom surface, and first and second side surfaces;
a first electrically conductive layer covering only a part of a first side surface thereby leaving an exposed area of the first side surface adjacent to the bottom surface, the first conductive layer in electrical contact with one of the respective laser diode bars;
a second electrically conductive layer covering only a part of a second side surface thereby leaving an exposed area of the second side surface adjacent to the bottom surface, the second electrically conductive layer in electrical contact with another one of the respective laser diode bars;
an electrical connector between the first and second electrically conductive layers; and
a metallic heat exchanger in thermal contact with the bottom surface of each of the submount cores.

2. The laser diode array of claim 1, wherein the bottom surface of the at least one submount is connected to the heat exchanger via a solder layer.

3. The laser diode array of claim 1, wherein the p-contacts and n-contacts of the laser diode bars are coupled to the conductive layers of the at least one submount via a solder layer or a solder foil.

4. The laser diode array of claim 3, wherein the solder is a gold-tin solder.

5. The laser diode array of claim 1, wherein the submount core is composed of one of the group of Aluminum Nitride (AlN), Beryllium Oxide (BeO) or CVD Diamond.

6. The laser diode array of claim 1, wherein the connector is a conductive layer on the top surface.

7. The laser diode array of claim 1, wherein the submount core includes a lateral side surface between the first and second side surfaces, wherein the connector is a lateral metal layer on the lateral side surface.

8. The laser diode array of claim 1, wherein the submount core includes a via between the side surfaces, wherein the connector is a conductive material in the via in electrical contact with the conductive layers.

9. The laser diode array of claim 1, wherein the conductive layers are one of a group of copper, gold, nickel, titanium and platinum.

10. A laser diode package to be used in a laser diode array having a plurality of laser diode packages, the laser diode package comprising:
a submount having an electrically insulative core with a top surface, a bottom surface, and first and second side surfaces located between the top and bottom surfaces, the submount having a continuous electrically conductive layer positioned on the top surface and on portions of the first and second side surfaces adjacent to the top surface, a lowermost end of the continuous electrically conductive layer on each of the first and second side surfaces being spaced away from the bottom surface of the electrically insulative core; and
a laser diode bar attached via a solder bond to the first side surface such that the laser diode emits energy from a region adjacent to the top surface.

11. The laser diode package of claim 10, further including a metallic layer on the bottom surface of the electrically insulative core for contacting a solder material to attach the laser diode package to a heat exchanger.

12. The laser diode package of claim 10, wherein the distance between the top and bottom surface of the submount is 1.5 to 2.4 mm, and a distance from the lowermost end of the continuous electrically conductive layer to the bottom layer is between about 20% to 40% of the distance between the top and bottom surface.

13. The laser diode package of claim 10, wherein the electrically insulative core is composed of one of the group of Aluminum Nitride (AlN), Beryllium Oxide (BeO) or CVD Diamond.

14. The laser diode package of claim 10, wherein the conductive layer is one of a group of copper, gold, nickel, titanium and platinum.

15. A laser diode array comprising:
a plurality of laser diode packages, each of the packages including:
a submount having an electrically insulative core with a top surface, a bottom surface, and first and second side surfaces located between the top and bottom surfaces, the submount having a continuous electrically conductive layer positioned on the top surface and on portions of the first and second side surfaces adjacent to the top surface, a lowermost end of the continuous electrically conductive layer on each of the first and second side surfaces being spaced away from the bottom surface of the electrically insulative core; and
a laser diode bar attached via a solder foil layer to the first side surface such that the laser diode emits energy from a region adjacent to the top surface; and
a thermal reservoir being thermally coupled to the bottom surfaces of each submount via a lower temperature solder than the solder foil layer.
